# EUROPEAN PATENT APPLICATION

(11) **EP 1 852 897 A1**
(43) Date of publication of application: **07.11.2007**
(21) Application number: 06713322.3
(22) Date of filing: 08.02.2006
(51) Int. Cl.: H01L 21/205, C23C 16/34, H01L 33/00

(54) **NITRIDE SEMICONDUCTOR MATERIAL AND METHOD FOR MANUFACTURING NITRIDE SEMICONDUCTOR CRYSTAL**

(30) Priority: 21.02.2005 JP 2005080384
(71) Applicant: Mitsubishi Chemical Corporation, Minato-ku Tokyo 108-0014 (JP)
(72) Inventor: KIYOMI, Kazumasa, mamiana-cho, Ushiku-shi, Ibaraki, 300129 (JP); HORIE, Hideyoshi, mamiana-cho, Ushiku-shi, Ibaraki, 300129 (JP); ISHIWATARI, Toshio, mamiana-cho, Ushiku-shi, Ibaraki, 300129 (JP); FUJIMURA, Isao, mamiana-cho, Ushiku-shi, Ibaraki, 300129 (JP)
(74) Representative: Naylor, Matthew John
(86) International application number: PCT/JP2006/302179
(87) International publication number: WO 2006/087958

(57) **Abstract**

A nitride semiconductor material comprising a semiconductor or dielectric substrate having thereon a first nitride semiconductor layer group, wherein the surface of the first nitride semiconductor layer group has an RMS of 5 nm or less, a variation of X-ray half-width within ±30%, a light reflectance of the surface of 15% or more, and a variation thereof of ±10% or less, and the thickness of said first nitride semiconductor layer group is 25 µm or more. This nitride semiconductor material is excellent in uniformity and stability, assured of a low production cost, and useful as a substrate for a nitride semiconductor-type device.

## Description

### TECHNICAL FIELD

The present invention relates to a nitride semiconductor material suitably used for a semiconductor device. The present invention also relates to a production process of a nitride semiconductor crystal useful for the production of the nitride semiconductor material.

### BACKGROUND ART

A compound semiconductor containing N and at least one element selected from Ga, Al, B, As, In, P and Sb (hereinafter referred to as a "nitride semiconductor") has been heretofore known to be a promising semiconductor material for light-emitting light-receiving devices because of its wide band gap of 1.9eV to 6.2eV and its band gap energy over a wide range from ultraviolet region to visible region. A representative example of this nitride semiconductor is a compound semiconductor represented by the formula: BₓAl_{y}Ga_{z}In_{1-x-y-z}N (wherein 0≤x≤1, 0≤y≤1, 0≤z≤1, 0≤x+y+z≤1). The nitride semiconductor device is produced by forming mainly sapphire as the substrate for growth, and at present, a light-emitting diode using a GaN film provided on the sapphire substrate and a nitride semiconductor film formed thereon is available on the market.

However, the lattice mismatch ratio between the sapphire substrate and GaN is as large as about 16%, and the defect density of the GaN film grown on the sapphire substrate becomes as large as 10⁹ cm⁻² to 10¹⁰ cm⁻². Such a high defect density gives rise to a short life of particularly a blue semiconductor laser formed on the sapphire substrate.

It is known that when a nitride semiconductor is grown on a substrate capable of growing a nitride semiconductor, the crystal defect can be decreased by increasing the film thickness. However, when a thick GaN film is formed on a sapphire substrate or the like, there arises a problem that cracking or crazing is generated in GaN and moreover, GaN is separated from the underlying substrate (see, Japanese Journal of Applied Physics, 32, page 1528 (1993), and R.P. Vaudo, et al., Proceedings Electrochemical Society, 98-18, pp. 79-86 (1999)).

Furthermore, for example, even when GaN is grown to hundreds of µm, there is sometimes generated a defect on the surface after growth or produced a plurality of growth planes (see, JP-A-10-173288 (the term "JP-A" as used herein means an "unexamined published Japanese patent application"), JP-A-10-316498, JP-A-2001-200366, JP-A-2002-184696, JP-T-2004-508268 (the term "JP-T" as used herein means a "published Japanese translation of a PCT patent application"), JP-A-10-256662, JP-A-2002-293697, JP-A-2003-7616, and Crystal Properties and Preparation, 32-34, page 154 (1991)).

Here, a most ideal substrate usable for the production of a GaN film is also a GaN substrate. However, the equilibrium vapor pressure of nitrogen is extremely high as compared with Ga and therefore, GaN can be hardly caused to make a bulk crystal growth by using a conventional pulling method. Accordingly, a method of growing a thick GaN film on a substrate comprising a material different from a nitride semiconductor, that is, a substrate comprising a heterogeneous material (for example, sapphire substrate, SiC substrate, Si substrate or GaAs substrate; hereinafter referred to as a "heterogeneous substrate"), and then removing the heterogeneous substrate, thereby producing a nitride semiconductor material, has been proposed (see, JP-A-10-256662, JP-A-2002-293697 and JP-A-2003-7616).

However, the GaN substrate produced by such a method is not always assured of a sufficiently stable quality in view of crystal uniformity or stability and is expensive as compared with the conventional sapphire substrate.

### DISCLOSURE OF THE INVENTION

Under these circumstances, an object of the present invention is to provide a nitride semiconductor material excellent in uniformity and stability despite a certain level of thickness of the nitride semiconductor crystal, assured of a low production cost, and useful as a substrate for a nitride semiconductor-type device. Another object of the present invention is to provide a production process of a nitride semiconductor crystal comprising a single growth plane, where even when the crystal is grown to a certain level of thickness, cracking or crazing is not generated and separation from the underlying substrate does not occur and where the surface polishing step is not required.

As a result of intensive investigations, the present inventors have found that these objects can be attained by the present invention having the following constitutions.

The present invention provides a nitride semiconductor material comprising a semiconductor or dielectric substrate having thereon a first nitride semiconductor layer group, wherein the surface of said first nitride semiconductor layer group has an RMS of 5 nm or less, a variation of X-ray half-width within ±30%, a light reflectance of the surface of 15% or more, and a variation thereof of ±10% or less, and the thickness of said first nitride semiconductor layer group is 25 µm or more.

The present invention also provides a production process of a nitride semiconductor crystal, comprising growing a nitride semiconductor crystal on a substrate by setting the conditions to satisfy at least either one of the following (1) and (2):
(1) the growth rate is set to 30 µm/h or more at the initiation of crystal growth, and
(2) the growth rate is gradually decreased along with the progress of crystal growth.

The nitride semiconductor material of the present invention is reduced in the dislocation defect present in the crystal and assured of good crystallinity and good surface flatness and therefore, can have a thickness advantageous for the production of a semiconductor device. When the production process of the present invention is used, such a nitride semiconductor material can be mass-produced at a low cost with the use of a conventional growth apparatus. In particular, this production process is greatly advantageous in that the crystal growth efficiency is high and a polishing step can be omitted.

### BRIEF DESCRIPTION OF THE DRAWINGS

Fig. 1 is an enlarged photograph of a GaN crystal formed on a sapphire substrate in Example 1.
Fig. 2 is a view showing the in-plane distribution of the half-width by the X-ray diffraction (0002) on the surface of the GaN crystal formed in Example 1.
Fig. 3 is a graph comparing the PL intensity on the GaN layer surface formed in Example 1.
Fig. 4 is a cross-sectional side view of a preferred reactor for implementing the production process of the present invention.
Fig. 5 is a cross-sectional side view showing that a polycrystal is formed in the reactor.

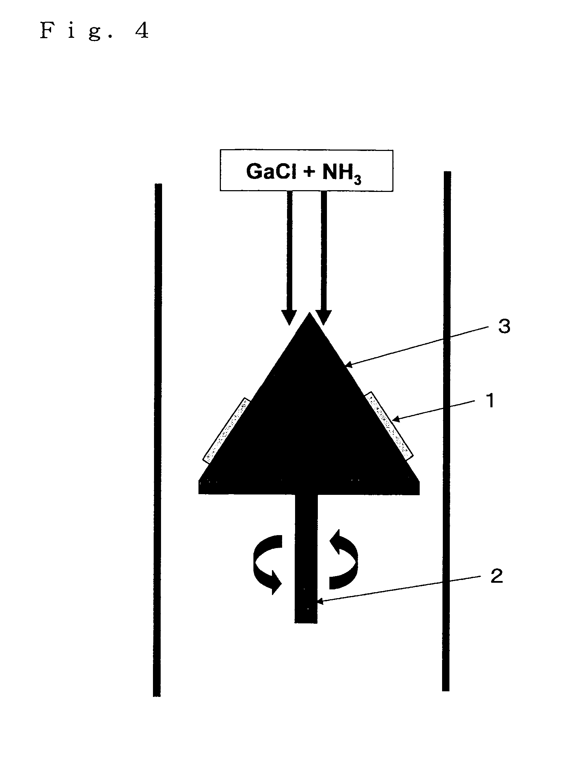

In Figs. 4 and 5, 1 is a substrate, 2 is a rotation axis, 3 is a susceptor, and 4 is a gallium nitride polycrystal.

### BEST MODE FOR CARRYING OUT THE INVENTION

The nitride semiconductor material and the production process of a nitride semiconductor crystal of the present invention are described in detail below. In the following, the constitutional requirements are sometimes described based on a representative embodiment of the present invention, but the present invention is not limited to such an embodiment. In the present invention, the numerical value range expressed by using "from (numerical value A) to (numerical value B)" means a range including the numerical values A and B as a lower limit value and an upper limit value, respectively.

The nitride semiconductor material of the present invention has a first nitride semiconductor layer group on a semiconductor or dielectric substrate.

In the present invention, the term "layer B formed on A" includes both a case where layer B is formed to bring the bottom surface of layer B into contact with the top surface of A, and a case where one or more layers are formed on the top surface of A and layer B is further formed on such layers. Furthermore, the above-described term also includes a case where the top surface of A and the bottom surface of layer B are partially contacted and in the non-contacted portion, one or more layer is present between A and layer B. Specific embodiments will become apparent from the following description of the substrate or each layer and Examples described later.

### (Substrate)

The semiconductor or dielectric substrate usable in the nitride semiconductor material of the present invention is not particularly limited in its kind as long as it has a diameter of usually 2 cm or more and can grow a first nitride semiconductor group described later on the surface. The substrate is preferably a substrate having a crystal structure belonging to the cubic or hexagonal system, and examples of the cubic system substrate include Si, GaAs, InGaAs, GaP, InP, ZnSe, ZnTe and CdTe. As for the hexagonal system substrate, sapphire, SiC, GaN, spinel, ZnO and the like may be used. The substrate is more preferably sapphire.

The semiconductor or dielectric substrate is not particularly limited in its specific shape as long as the diameter is 2 cm or more. The term "the diameter is 2 cm or more" as used herein means that the substrate has a size large enough to cut out a circle having a diameter of 2 cm, and the substrate may not have a circular shape but may have, for example, a rectangular shape with one side being 2 cm or more. The diameter is preferably 2.5 cm or more, more preferably 5 cm or more. The thickness of the substrate may be sufficient if it causes no trouble in the handling at the production or on use. The thickness is usually from 100 µm to 1 mm, preferably from 200 µm to 750 µm, more preferably from 300 µm to 500 µm.

In the present invention, an off-substrate may also be used. For example, in the case of a sapphire substrate, a substrate where the plane on which the nitride semiconductor material is grown is an (ABCD) plane or a plane slightly inclined from the (ABCD) plane wherein A, B, C and D each is a natural number, may be used. The angle of this slight inclination is usually from 0° to 10°, preferably from 0° to 0.50°, more preferably from 0° to 0.20°. For example, a sapphire substrate where the crystal growth plane is slightly inclined from the (0001) plane to the m-axis direction may be preferably used. Other than these, for example, an a(11-20) plane, an r(1-102) plane, an m(1-100) plane, and respective equivalent planes may also be used. The equivalent plane as used herein means a plane which comes to have crystallographically the same atomic arrangement when rotated at 90° in the cubic system or at 60° in the hexagonal system.

### (First Nitride Semiconductor Layer Group)

The nitride semiconductor material of the present invention is characterized by having a first nitride semiconductor layer group on the semiconductor or dielectric substrate.

The first nitride semiconductor layer group may comprise a single layer or a plurality of layers. In the case of comprising a plurality of layers, the plurality of layers may be formed from different materials or may be formed from the same material but under different growth conditions by changing the growth temperature or growth rate. Also, the layers constituting first nitride semiconductor layer group each may contain, for example, in the case of GaN layer, a layer where the mixed crystal ratio of Al or In is continuously changed.

The layers constituting first nitride semiconductor layer group each may be doped. The carrier concentration is usually from 1×10¹⁷ cm⁻³ to 1×10¹⁹ cm⁻³, preferably from 5×10¹⁷ cm⁻³ to 5×10¹⁸ cm⁻³, more preferably from 1×10¹⁸ cm⁻³ to 2×10¹⁸ cm⁻³. For example, in the case where the first nitride semiconductor layer group contains an n-type GaN, the n-type GaN preferably comprises at least one element selected from silicon, oxygen and carbon. Also, in the case where the first nitride semiconductor layer group contains a semi-insulating GaN, the semi-insulating GaN preferably comprises at least one element selected from Fe, Cr, C and Zn.

The thickness of the first nitride semiconductor layer group is usually 25 µm or more, preferably from 25 µm to 500 µm, more preferably from 30 µm to 300 µm, still more preferably from 50 µm to 250 µm, yet still more preferably from 100 µm to 200 µm, and still even more preferably from 130 µm to 180 µm.

The first nitride semiconductor layer group preferably has no spatial periodicity of the defect density with respect to its in-plane direction.

The surface of the first nitride semiconductor layer group has RMS of 5 nm or less, preferably 3 nm or less, more preferably 1 nm or less, still more preferably 0.8 nm or less. The RMS as used herein indicates surface roughness and as the value is smaller, this means that the surface state is better. In the present invention, the RMS is determined by calculating a root mean square from the data obtained when the surface roughness on a 10-µm square is measured by AFM.

The surface of the first nitride semiconductor layer group preferably comprises the same kind of facets and contains no different kind of facet, that is, preferably contains no facet except for the facets grown at the initial state. This means that in the case where the first nitride semiconductor layer group comprises a plurality of layers, the lastly formed layer does not have a facet except for the initial growth plane of the layer formed first on a second nitride semiconductor layer which is described later. When the surface has no facet except for the initially grown facet, this means that only the same facet as the growth-initiating facet is present on the surface. Otherwise, when the growth is initiated on the different facet, for example, on the C plane, generation of an a-plane, an r-plane or an m-plane is caused and such different facets can be confirmed by observing the wafer with an eye at various inclination angles, because light is glitteringly reflected at an angle except for the C plane.

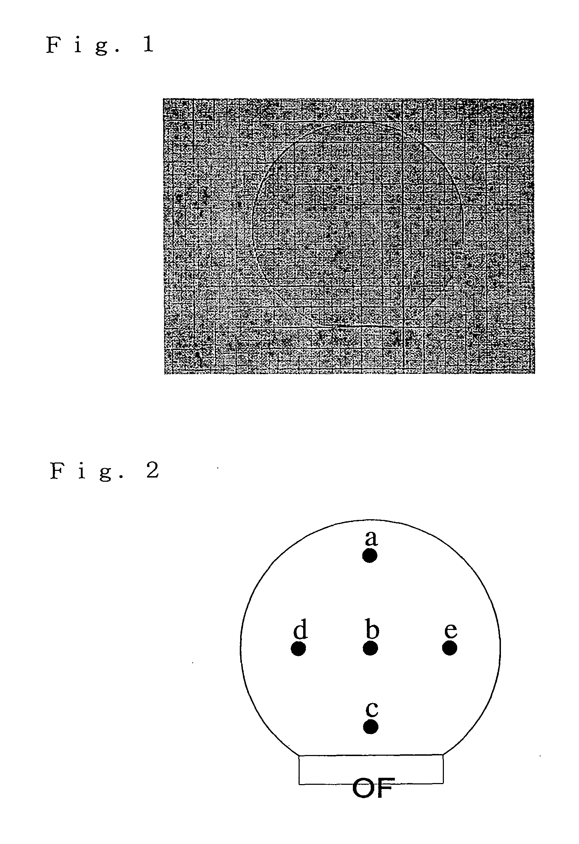

Furthermore, the variation of X-ray half-width on the surface of the first nitride semiconductor layer group is within ±30%, preferably within ±20%, more preferably within ±10%, still more preferably ±5%, yet still more preferably within ±1%. The X-ray half-width can be measured by the commonly employed X-ray diffraction. Also, the variation of the X-ray half-width as used herein can be determined by the calculation of, as shown in Fig. 2, selecting 5 or more portions on the surface of the first nitride semiconductor layer group, measuring the X-ray half-width at these portions, and dividing 1/2 of the difference between the maximum value and the minimum value by the average value.

Similarly to the above, the variation of the light reflectance on the surface of the first nitride semiconductor layer group is within ±10%, preferably within ±8%, more preferably within ±5%, still more preferably within ±3%, yet still more preferably within ±1%. The light reflectance can be measured by the commonly employed reflectance measuring apparatus. Also, the variation of light reflectance as used herein can be determined by the calculation of selecting 5 or more portions on the surface of the second nitride semiconductor layer group, measuring the X-ray half-width at these portions, and dividing 1/2 of the difference between the maximum value and the minimum value by the average value.

### (Second Nitride Semiconductor Layer Group)

The nitride semiconductor material of the present invention may have a second nitride semiconductor layer group between the semiconductor or dielectric substrate and the first nitride semiconductor layer group. Specific examples of the nitride semiconductor constituting the second nitride semiconductor layer group include InₓGa₁₋ₓN (0≤x≤1), Al_{y}Ga_{1-y}N (0≤y≤1) and InₓAl_{y}Ga_{z}N (x+y+z=1). In each layer constituting the second nitride semiconductor layer, the mixed crystal ratio or the like may be continuously changed. Also, the second nitride semiconductor layer group preferably has no spatial periodicity of the crystal defect with respect to the in-plane direction of the substrate.

The second nitride semiconductor layer group may comprise a single layer or a plurality of layers. In the case of comprising a plurality of layers, for example, a layer containing Al or In may be inserted in the form of a single layer into the GaN layer or the layers may comprise superlattice of GaN and AlInGaN. Furthermore, the layers may have a structure of decreasing the dislocation generated due to difference in the lattice constant, such as a structure of inserting a material generating a lattice constant difference between the material and the substrate larger than the lattice constant difference generated between the substrate and the material constituting the second layer surface. The second nitride semiconductor layer group may exhibit a single conductivity type or a plurality of different conductivity types.

For example, when the second nitride semiconductor layer group contains an n-type GaN, the n-type GaN preferably comprises at least one element selected from silicon, oxygen and carbon. Also, when the second nitride semiconductor layer group contains a p-type GaN, the p-type GaN preferably comprises at least one element selected from Zn and Mg.

The thickness of the second nitride semiconductor layer group is usually from 1 µm to 50 µm, preferably from 2 µm to 10 µm, more preferably from 3 µm to 5 µm.

The total thickness of the first nitride semiconductor layer group and second nitride semiconductor layer group is usually from 11 µm to 550 µm, preferably from 30 µm to 350 µm, more preferably from 50 µm to 250 µm, still more preferably from 100 µm to 200 µm, yet still more preferably from 130 µm to 180 µm.

### (Production Process)

The production process for the nitride semiconductor material of the present invention having such characteristic features is not particularly limited, but this production process is specifically described below by referring to a preferred production process. In the following, a case where a second nitride semiconductor layer is provided is described.

First, a second nitride semiconductor layer is grown on a substrate. The growth of the second nitride semiconductor layer may be either vapor phase growth or liquid phase growth but is preferably vapor phase growth. The method for the vapor phase growth may be a metal-organic vapor phase epitaxy method (MOVPE method), a pulsed laser deposition method, a pulsed electron deposition method, a hydride vapor phase epitaxy method (HVPE method), a molecular beam epitaxy method or a liquid phase growth method, but the vapor phase growth is preferably performed by a metal-organic vapor phase epitaxy method or a hydride vapor phase epitaxy method. Subsequently, a first nitride semiconductor layer is further grown on the formed second nitride semiconductor layer. The growth method of the first nitride semiconductor layer may be a hydride vapor phase epitaxy method or a liquid phase growth method but is preferably a hydride vapor phase epitaxy method.

The nitride semiconductor material of the present invention is preferably produced by utilizing a process of flowing a gas from an angle of 45° to 90° with respect to the normal line of the substrate surface, thereby growing a nitride semiconductor crystal on the substrate. In other words, at the time of growing the second nitride semiconductor layer group and the first nitride semiconductor layer group on the substrate, the gas is preferably flowed from that angle. At the growth by flowing a gas from the above-described angle, the layers constituting the first nitride semiconductor layer group and the second nitride semiconductor layer group need not be all grown, but preferably, at least a layer on the surface side out of the layers constituting the first nitride semiconductor layer group is grown, more preferably, all layers constituting the first nitride semiconductor layer group are grown, still more preferably, all layers constituting the first nitride semiconductor layer group and the second nitride semiconductor layer group are grown. The angle from which the gas is flowed is more preferably from 60° to 90°, still more preferably from 70° to 90°, yet still more preferably from 80° to 90°, with respect to the normal line of the substrate surface.

In conventional methods, a gas is flowed at right angle to the substrate surface so as to increase the crystal growth rate as much as possible. By flowing a gas in this way, the growth rate is increased to 150 µm/h or more, but a large defect density results due to thickness distribution in the wafer plane or high growth rate. Furthermore, in the case of using a vertical reactor, the wafer is disposed to face up and when a foreign matter such as dust falls from the above, the foreign matter gives rise to the reduction of crystal quality.

By virtue of flowing a gas as described above, for example, at an angle with respect to the normal line of the substrate surface, those problems can be overcome and a film assured of very high uniformity in the film thickness of nitride semiconductor or the quality of crystal can be obtained. When a gas is flowed at right angle to the substrate, the gas concentration is caused to differ between the center portion and the peripheral portion of the substrate, but by flowing a gas at an angle with respect to the normal line of the substrate surface, the gas concentration unevenness in the substrate plane can be suppressed.

In the present invention, a plurality of nitride semiconductor layers are preferably grown by flowing a gas at an angle with respect to the normal line of the substrate surface. For example, in the case of forming the second nitride semiconductor layer on the substrate and then forming thereon the first nitride semiconductor layer, the growth rate is preferably controlled from the initiation of growth of the nitride semiconductor crystal for the first nitride semiconductor layer so as to improve the surface property. More specifically, the growth is preferably performed to satisfy at least one, more preferably both, of the following two conditions:
(1) the growth rate is set to 30 µm/h or more at the initiation of crystal growth of the first nitride semiconductor layer, and
(2) the growth rate is gradually decreased along with the progress of crystal growth of the first nitride semiconductor layer.

The growth rate of the second nitride semiconductor layer is preferably set to 5 µm/h or less.

By decreasing the initial growth rate of the first nitride semiconductor layer as compared with the case of disposing the substrate at right angle to the gas flow, the crystallinity can be significantly enhanced from the initiation of growth of the nitride semiconductor. For example, in the case where the growth rate is set to 30 µm/h at the initiation of growth of the first nitride semiconductor layer, the growth rate gradually decreases along with the progress of growth and when the crystal is grown to a thickness by far larger than 200 µm, the growth rate tends to decrease to about 20 µm/h or less and thereafter, become constant. Usually, the growth rate becomes constant at about 5 µm/h to 20 µm/h. This reduction in the growth rate is considered to have an effect of flattening the slightly roughened surface in the portion of initial growth at a high growth rate.

In order to flatten the surface, a difference is preferably provided between the temperature at the substrate end part on the upstream side with respect to the gas flow and the temperature at the substrate end part on the downstream side. More specifically, the temperature on the upstream side is preferably set to be high while setting the temperature on the downstream side to be low. When the substrate length (distance from the substrate end part on the upstream side to the substrate end part on the downstream side) is 15 cm, the difference in the temperature between the upstream side and the downstream side is usually from 10°C to 100°C, preferably from 15°C to 75°C, more preferably from 20°C to 45°C. That is, the temperature difference per unit length of the substrate is usually from 0.5°C/cm to 10.0°C/cm, preferably from 0.67°C/cm to 6.7°C/cm, more preferably from 1.0°C/cm to 5.0°C/cm, still more preferably from 1.3°C/cm to 3.0°C/cm. When such a temperature difference is provided, a flatter and more uniform surface is readily formed from the upstream side to the downstream side.

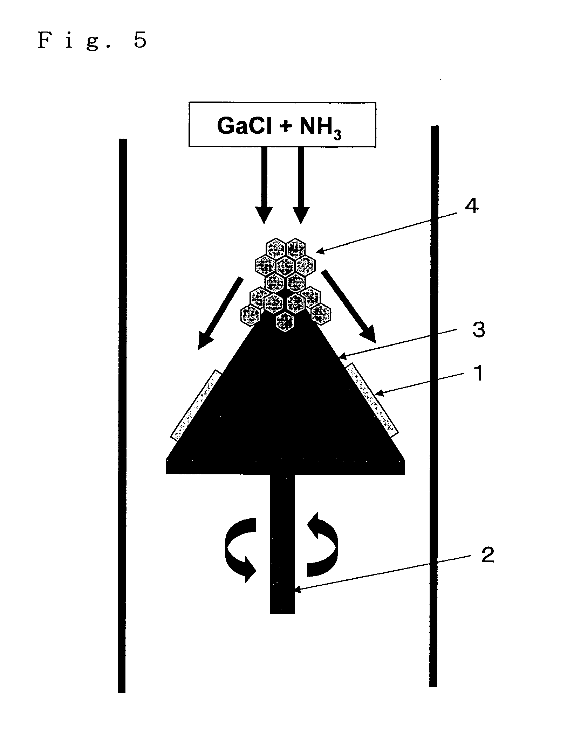

Fig. 4 is a view showing an example of the preferred reactor for producing the nitride semiconductor material of the present invention. A substrate 1 is disposed as shown on a polygonal cone-shaped susceptor 3 with a rotation axis 2 and while rotating the rotation axis 2 in the arrow direction, a mixed gas of gallium chloride and ammonia is flowed from the above. The mixed gas first comes into contact with the top part of the susceptor 3, then runs down from the top part along the side surface of the susceptor 3 and further flows down over the substrate 1. At this time, as shown in Fig. 5, a polycrystal 4 is formed at the top part as well as in the vicinity thereof, and the mixed gas passing through the polycrystal flows to the substrate 1. A structure capable of forming a polycrystal may be disposed at the top part of the susceptor 3. For example, a cap not overlapping with the substrate (wafer) may be disposed. This cap preferably causes no interference with the wafer and is removable and exchangeable.

The height of the polygonal cone-shaped susceptor is usually from 8.0 cm to 20.0 cm, preferably from 9.0 cm to 15.0 cm, more preferably from 10.0 cm to 13.0 cm. Also, the bottom surface shape of the polygonal cone-shaped susceptor is preferably designed to form a polygon inscribed in a circle having a diameter in the following range. That is, the diameter of the inscribed circle is usually from 40 cm to 80 cm, preferably from 50 cm to 75 cm, more preferably from 60 cm to 70 cm. The substrate is disposed at a position where the gallium nitride polycrystal 4 shown in Fig. 5 does not come into contact with the substrate at the production. Usually, the substrate is disposed at the position from 1 cm to 10 cm, preferably from 2 cm to 8 cm, more preferably from 3 cm to 4 cm, lower than the top part. The rotation speed of the susceptor is usually from 5 rpm to 30 rpm, preferably from 5 rpm to 20 rpm, more preferably from 5 rpm to 15 rpm.

At the time of producing the nitride semiconductor material of the present invention, a hydrogen chloride gas may also be mixed in the mixed gas supplied into the reactor. The hydrogen chloride gas may be continuously flowed at a constant flow rate from the initiation to the end of growth, or the flow rate may be changed along with the progress of growth. In a preferred embodiment, the flow rate of the hydrogen chloride gas is decreased along with the growth of gallium nitride polycrystal formed at the top part of susceptor and in the vicinity thereof. In other words, it is preferred to flow the hydrogen chloride gas in an amount large enough to suppress the production of polycrystal at the initiation of growth and gradually decrease the flow rate along with the progress of growth.

This method is also advantageous in that the dislocation generated at the growth of the second nitride semiconductor layer is hardly propagated to the first nitride semiconductor layer. For example, when a GaN film is grown by an HVPE apparatus according to the above-described method on a film of about 3 µm having a dislocation grown during MOVPE, the dislocation is not propagated and this is preferred.

As described above, when the gas is flowed at an angle with respect to the normal line of the substrate surface, cracking or crazing is not generated even in a thick film of about 200 µm, separation from the underlying substrate does not occur, the surface has gloss and therefore, requires no polishing step, and a surface having a growth plane comprising a single face can be formed. Since a polishing step is not necessary, the production cost or production time can be greatly reduced and the produced semiconductor material can be advantageously used as it is for the subsequent process.

### (Application)

The nitride semiconductor material obtained by the present invention may be utilized in various fields. For example, this nitride semiconductor material is useful as a substrate for a nitride semiconductor device and by forming a semiconductor layer as a third layer group on the nitride semiconductor material of the present invention, a nitride semiconductor device can be provided. More specifically, a layer having any one function of a light-emitting element, a light-receiving element, a photo-coupler, a thermoelectric conversion element, a solar cell element, a photosensor, a switching element, an inverter, a delay element, a logic circuit, a rectifier, an oscillation element, a current amplification element, a voltage control element, a resistance for current, a capacitor for electric charge, an inductance for current, an ultrasonic propagation element and a light-sound wave interacting element, or having an integrated function thereof may be provided on the second layer group and the first layer group.

After such a semiconductor layer as the third layer group is formed, a layer for the purpose of, for example, enhancing the output of light may be also formed thereon as a fourth layer group. Furthermore, in the case of fabricating the above-described light-emitting or light-receiving element, the element itself is sometimes fabricated in the reverse arrangement to the growth direction (for example, flip chip), and at this time, the nitride semiconductor material of the present invention may also be used to ensure a thick layer group necessary as the base of the element. In addition, the nitride semiconductor material of the present invention may be used as a substrate, for example, after separating the first nitride semiconductor layer from the sapphire substrate by a laser separation method or the like, the separated nitride semiconductor layer may be used as various substrates. Needless to say about the modes described above, the present invention is also applicable to other various modes.

The present invention is described in greater detail below by referring to Examples. The materials, amounts used, ratios, processing contents, processing procedures and the like described in the following Examples can be appropriately changed or modified without departing from the purport of the present invention. Accordingly, the scope of the present invention should not be construed as being limited to these specific examples.

### (Example 1)

A 3 µm-thick undoped GaN was grown by the MOVPE method on a circular substrate having a diameter of 5.08 cm (2 inches) and a thickness of 430 µm and being 0.15° offed (slightly inclined) from the sapphire (0001) plane toward the m-axis direction. Thereafter, the substrate having grown thereon the GaN layer was placed in an HVPE apparatus and after arranging the substrate so that a gas flow can make an angle of 80° with respect to the normal line of the substrate, the GaN layer was grown. The conditions of growth by the HVPE method were set as follows.
HCl Partial pressure:
   1.14 kPa (1.13×10⁻² atm) (HCl reacts with a Ga metal to produce GaCl)
NH₃ Partial pressure: 4.58 kPa (4.52×10⁻² atm)
Growth temperature:
   1,000°C (substrate end part on the upstream side)
   970°C (substrate end part on the downstream side)
Carrier gas: H₂ (16 [L])
Growth time: 5 hours

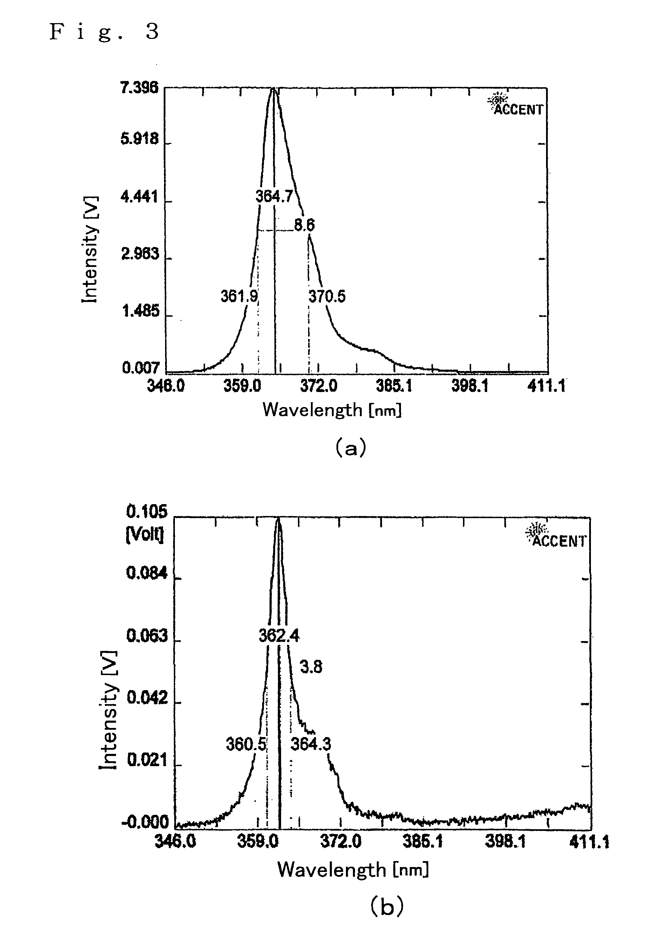

As seen in Fig. 1 showing the GaN layer crystal after growth, the thickness was 170 µm, and concentration of a spatial periodic defect such as cracking or crazing was not generated on the surface. Usually, when a crystal is grown to such a large thickness, an n-sided pyramidal defect is generated in a large plane with a diameter of 5 cm or more. However, this wafer was free of such a defect and showed a mirror face, and a crystal plane other than the crystal plane grown at the initial stage was not observed. The half-width in the wafer center (b in Fig. 2) by the X-ray diffraction (0002) was 183.1 (arcaec). Also, as shown in Fig. 2, when the half-width by X-ray was measured at four portions selected on the wafer surface, the half-width was 185.5 (arcaec) at the a point, 202.8 (arcaec) at the c point, 188.0 (arcaec) at the d point, and 189.7 (arcaec) at the e point, and the variation in the plane was within ±6%. The RMS value on the grown surface was 0.7 nm. Furthermore, when the peak intensity of band-end emission was measured by the PL (photoluminescence) measurement of surface, the GaN film (Fig. 3(a) with a thickness of 200 µm exhibited light emission intensity as high as 70 times that of a 3-µm film grown by the MOVPE method (Fig. 3(b)). The reflectance of light at 365 nm on the wafer surface as measured by using a halogen lamp was 19.6%, and the variation thereof in the plane was 7.4%.

### (Example 2)

A 3 µm-thick undoped AlGaN layer was grown by the MOVPE method on a circular sapphire (0001) substrate having a diameter of 5.08 cm (2 inches) and a thickness of 430 µm. Thereafter, the substrate having grown thereon the AlGaN layer was disposed in an HVPE apparatus so that the substrate surface can be parallel to a gas flow (so that the gas flow can make an angle of 90° with respect to the normal line of the substrate surface). The conditions of growth by the HVPE method were set as follows.
HCl Partial pressure:
   1.14 kPa (1.13×10⁻² atm) (HCl reacts with a Ga metal to produce GaCl)
NH₃ Partial pressure: 4.58 kPa (4.52×10⁻² atm)
Growth temperature:
   1,000°C (substrate end part on the upstream side)
   970°C (substrate end part on the downstream side)
Carrier gas: H₂ (16 [L])
Growth time: 5 hours

The thickness of the GaN layer crystal after growth was 170 µm, and concentration of a spatial periodic defect such as cracking or crazing was not generated on the surface. Usually, when a crystal is grown to such a large thickness, an n-sided pyramidal defect is generated in a large plane with a diameter of 5 cm or more. However, this wafer was free of such a defect and showed a mirror face, and a plane other than the plane grown at the initial stage was not observed. The half-width by the X-ray diffraction (0002) was 200 (arcaec), and the variation in the plane was within ±10%. The RMS value on the surface was 0.8 nm. Also, the reflectance of light at 365 nm on the wafer surface as measured by using a halogen lamp was 16.2%, and the variation thereof in the plane was 9.0%.

### (Example 3)

A 1.5 µm-thick undoped GaN layer was grown by the MOVPE method on a circular sapphire (0001) substrate having a diameter of 5.08 cm (2 inches) and a thickness of 430 µm. Subsequently, a superlattice buffer layer where an InGaN layer and a GaN layer each having a film thickness of 10 nm were alternately inserted in 5 cycles (5 InGaN layers and 5 GaN layers), was formed thereon, and a 1.5 µm-thick undoped GaN layer was further grown thereon. This substrate was disposed in an HVPE apparatus so that the substrate can be parallel to a gas flow (so that the gas flow can make an angle of 90° with respect to the normal line of the substrate surface). The conditions of growth by the HVPE method were set as follows.
HCl Partial pressure:
   1.14 kPa (1.13×10⁻² atm) (HCl reacts with a Ga metal to produce GaCl)
NH₃ Partial pressure: 4.58 kPa (4.52×10⁻² atm)
Growth temperature:
   1,000°C (substrate end part on the upstream side)
   970°C (substrate end part on the downstream side)
Carrier gas: H₂ (16 [L])
Growth time: 5 hours

The thickness of the GaN layer crystal after growth was 200 µm, and concentration of a spatial periodic defect such as cracking or crazing was not generated on the surface. Usually, when a crystal is grown to such a large thickness, an n-sided pyramidal defect is generated in a large plane with a diameter of 5 cm or more. However, this wafer was free of such a defect and showed a mirror face, and a crystal plane other than the crystal plane grown at the initial stage was not observed. The half-width by the X-ray diffraction (0002) was 185 (arcaec), and the variation in the plane was within ±10%. The RMS value on the surface was 1 nm. Also, the reflectance of light at 365 nm on the wafer surface as measured by using a halogen lamp was 16.8%, and the variation thereof in the plane was 9.4%.

### (Example 4)

A 1.5 µm-thick undoped GaN layer was grown by the MOVPE method on a circular sapphire (0001) substrate having a diameter of 5.08 cm (2 inches) and a thickness of 430 µm. Subsequently, a superlattice buffer layer where an AlGaN layer and a GaN layer each having a film thickness of 10 nm were alternately inserted in 5 cycles (5 AlGaN layers and 5 GaN layers), was formed thereon, and a 1.5 µm-thick undoped GaN layer was further formed thereon. This substrate was placed in an HVPE apparatus and after arranging the substrate so that a gas flow can make an angle of 80° with respect to the normal line of the substrate surface, the GaN layer was grown. The conditions of growth by the HVPE method were set as follows.
HCl Partial pressure:
   1.14 kPa (1.13×10⁻² atm) (HCl reacts with a Ga metal to produce GaCl)
NH₃ Partial pressure: 4.58 kPa (4.52×10⁻² atm)
Growth temperature:
   1,000°C (substrate end part on the upstream side)
   970°C (substrate end part on the downstream side)
Carrier gas: H₂ (16 [L])
Growth time: 5 hours

The thickness of the GaN layer crystal after growth was 170 µm, and concentration of a spatial periodic defect such as cracking or crazing was not generated on the surface. Usually, when a crystal is grown to such a large thickness, an n-sided pyramidal defect is generated in a large plane with a diameter of 5 cm or more. However, this wafer was free of such a defect and showed a mirror face, and a crystal plane other than the crystal plane grown at the initial stage was not observed. The half-width by the X-ray diffraction (0002) was 150 (arcaec), and the variation in the plane was within ±10%. The RMS value on the surface was 1 nm. Also, the reflectance of light at 365 nm on the wafer surface as measured by using a halogen lamp was 16.2%, and the variation thereof in the plane was 9.4%.

### (Example 5)

A 3 µm-thick undoped GaN layer was grown by the MOVPE method on a circular sapphire (0001) substrate having a diameter of 5.08 cm (2 inches) and a thickness of 430 µm. Thereafter, the substrate was placed in an HVPE apparatus and after arranging the substrate so that a gas flow can make an angle of 80° with respect to the normal line of the substrate surface, the GaN layer was grown. The conditions of growth by the HVPE method were set as follows.
HCl Partial pressure:
   1.14 kPa (1.13×10⁻² atm) (HCl reacts with a Ga metal to produce GaCl)
NH₃ Partial pressure: 4.58 kPa (4.52×10⁻² atm)
SiH₄ Partial pressure: 0.286 Pa (2.82×10⁻⁶ atm)
Growth temperature:
   1,000°C (substrate end part on the upstream side)
   970°C (substrate end part on the downstream side)
Carrier gas: H₂ (16 [L])
Growth time: 5 hours

The thickness of the GaN layer crystal after growth was 170 µm, and concentration of a spatial periodic defect such as cracking or crazing was not generated on the surface. Usually, when a crystal is grown to such a large thickness, an n-sided pyramidal defect is generated in a large plane with a diameter of 5 cm or more. However, this wafer was free of such a defect and showed a mirror face, and a crystal plane other than the crystal plane grown at the initial stage was not observed. The half-width by the X-ray diffraction (0002) was 170 (arcaec), and the variation in the plane was within ±10%. The RMS value on the surface was 1 nm, and the carrier concentration in the thick film was 2×10¹⁸ cm⁻³. Also, the reflectance of light at 365 nm on the wafer surface as measured by using a halogen lamp was 17.8%, and the variation thereof in the plane was 8.5%.

### (Example 6)

A 3 µm-thick Si-doped GaN layer was grown by the MOVPE method on a circular sapphire (0001) substrate having a diameter of 5.08 cm (2 inches) and a thickness of 430 µm. Thereafter, the substrate was placed in an HVPE apparatus and after arranging the substrate so that a gas flow can make an angle of 80° with respect to the normal line of the substrate surface, the GaN layer was grown. The conditions of growth by the HVPE method were set as follows.
HCl Partial pressure:
   1.14 kPa (1.13×10⁻² atm) (HCl reacts with a Ga metal to produce GaCl)
NH₃ Partial pressure: 4.58 kPa (4.52×10⁻² atm)
SiH₄ Partial pressure: 0.286 Pa (2.82×10⁻⁶ atm)
Growth temperature:
   1,000°C (substrate end part on the upstream side)
   970°C (substrate end part on the downstream side)
Carrier gas: H₂ (16 [L])
Growth time: 5 hours

The thickness of the GaN layer crystal after growth was 170 µm, and concentration of a spatial periodic defect such as cracking or crazing was not generated on the surface. Usually, when a crystal is grown to such a large thickness, an n-sided pyramidal defect is generated in a large plane with a diameter of 5 cm or more. However, this wafer was free of such a defect and showed a mirror face, and a crystal plane other than the crystal plane grown at the initial stage was not observed. The half-width by the X-ray diffraction (0002) was 180 (arcaec), and the variation in the plane was within ±10%. The RMS value on the surface was 1 nm, and the carrier concentration in the thick film was 2x10¹⁸ cm⁻³. Also, the reflectance of light at 365 nm on the wafer surface as measured by using a halogen lamp was 19.5%, and the variation thereof in the plane was 8.8%.

### (Example 7)

A 3 µm-thick undoped GaN layer was grown by the MOVPE method on a circular sapphire (11-20) substrate having a diameter of 5.08 cm (2 inches) and a thickness of 430 µm. Thereafter, the substrate was placed in an HVPE apparatus and after arranging the substrate so that a gas flow can make an angle of 80° with respect to the normal line of the substrate surface, the GaN layer was grown. The conditions of growth by the HVPE method were set as follows.
HCl Partial pressure:
   1.14 kPa (1.13×10⁻² atm) (HCl reacts with a Ga metal to produce GaCl)
NH₃ Partial pressure: 4.58 kPa (4.52×10⁻² atm)
SiH₄ Partial pressure: 0.286 Pa (2.82×10⁻⁶ atm)
Growth temperature: 1,000°C
Growth time: 5 hours

The thickness of the GaN layer crystal after growth was 170 µm, and concentration of a spatial periodic defect such as cracking or crazing was not generated on the surface. Usually, when a crystal is grown to such a large thickness, an n-sided pyramidal defect is generated in a large plane with a diameter of 5 cm or more. However, this wafer was free of such a defect and showed a mirror face, and a crystal plane other than the crystal plane grown at the initial stage was not observed. The half-width by the X-ray diffraction (0002) was 250 (arcaec), and the variation in the plane was within ±10%. The RMS value on the surface was 1 nm, and the carrier concentration in the thick film was 2x10¹⁸ cm⁻³.

### (Example 8)

A 3 µm-thick undoped GaN layer was grown by the HVPE method on a circular sapphire (0001) substrate having a diameter of 5.08 cm (2 inches) and a thickness of 430 µm. Subsequently, the GaN layer was grown in an HVPE apparatus under the following conditions. At this time, from the initiation of growth of the undoped GaN layer, the substrate was disposed so that a gas flow can make an angle of 80° with respect to the normal line of the substrate surface.
HCl Partial pressure:
   1.14 kPa (1.13×10⁻² atm) (HCl reacts with a Ga metal to produce GaCl)
NH₃ Partial pressure: 4.58 kPa (4.52×10⁻² atm)
SiH₄ Partial pressure: 0.286 Pa (2.82×10⁻⁶ atm)
Growth temperature: 1,000°C
Growth time: 5 hours

The thickness of the GaN layer crystal after growth was 170 µm, and concentration of a spatial periodic defect such as cracking or crazing was not generated on the surface. Usually, when a crystal is grown to such a large thickness, an n-sided pyramidal defect is generated in a large plane with a diameter of 5 cm or more. However, this wafer was free of such a defect and showed a mirror face, and a crystal plane other than the crystal plane grown at the initial stage was not observed. The half-width by the X-ray diffraction (0002) was 185 (arcaec), and the variation in the plane was within ±10%. The RMS value on the surface was 1 nm, and the carrier concentration in the thick film was 2x10¹⁸ cm⁻³.

### (Example 9)

A 3 µm-thick p-type (Mg) doped GaN layer was grown by the MOVPE method for performing the nucleation of GaN on a circular substrate having a diameter of 5.08 cm (2 inches) and a thickness of 430 µm and being 0.15° offed (slightly inclined) from the sapphire (0001) plane toward the m-axis direction. Thereafter, the substrate was placed in an HVPE apparatus and after arranging the substrate so that a gas flow can make an angle of 75° with respect to the normal line of the substrate surface, the GaN layer was grown. The conditions of growth by the HVPE method were set as follows.
HCl Partial pressure:
   1.14 kPa (1.13×10⁻² atm) (HCl reacts with a Ga metal to produce GaCl)
NH₃ Partial pressure: 4.58 kPa (4.52×10⁻² atm)
Growth temperature: 1,000°C
Growth time: 5 hours

The thickness of the GaN layer crystal after growth was 170 µm, and concentration of a spatial periodic defect such as cracking or crazing was not generated on the surface. Usually, when a crystal is grown to such a large thickness, an n-sided pyramidal defect is generated in a large plane with a diameter of 5 cm or more. However, this wafer was free of such a defect and showed a mirror face, and a crystal plane other than the crystal plane grown at the initial stage was not observed. The half-width in the wafer center by the X-ray diffraction (0002) was 183.1 (arcaec), and the variation in the plane was within ±6%. The RMS value on the grown surface was 0.7 nm. Furthermore, when the peak intensity of band-end emission was measured by the surface PL (photoluminescence) measurement, the GaN film with a thickness of 200 µm exhibited light emission intensity as high as 70 times that of a 3-µm film grown by the MOVPE method. The reflectance on the wafer surface as measured by using a halogen lamp was 18.5%, and the variation thereof in the plane was 10% or less.

### (Example 10)

A 3 µm-thick undoped GaN was grown by the MOVPE method on a circular substrate having a diameter of 5.08 cm (2 inches) and a thickness of 430 µm and being 0.15° offed (slightly inclined) from the sapphire (0001) plane toward the m-axis direction. Thereafter, the substrate having grown thereon the GaN layer was placed in an HVPE apparatus and after arranging the substrate so that a gas flow can make an angle of 80° with respect to the normal line of the substrate, the GaN layer was grown. The conditions of growth by the HVPE method were set as follows.
HCl Partial pressure:
   1.14 kPa (1.13×10⁻² atm) (HCl reacts with a Ga metal to produce GaCl)
NH₃ Partial pressure: 4.58 kPa (4.52×10⁻² atm)
Growth temperature:
   1,000°C (on the wafer top)
   970°C (on the wafer bottom)
Carrier gas: H₂ (16 [L])
Growth time: 5 hours

At this time, separately from the piping to the Ga reservoir, the HCl partial pressure was gradually decreased to 84.4 Pa (8.33×10⁻⁴ atm) for the first one hour, to 56.3 Pa (5.56×10⁻⁴ atm) for the next 2 hours, and further to 28.1 Pa (2.78×10⁻⁴ atm) for the next one hour.

The thickness of the GaN layer crystal after growth was 110 µm, and concentration of a spatial periodic defect such as cracking or crazing was not generated on the surface. This wafer showed a mirror face, and a crystal plane other than the crystal plane grown at the initial stage was not observed. The half-width in the wafer center (b in Fig. 2) by the X-ray diffraction (0002) was 226.0 (arcaec), and the variation in the plane was within ±15%. The RMS value on the grown surface was 0.7 nm. Also, the reflectance of light at 365 nm on the wafer surface as measured by using a halogen lamp was 19.5%, and the variation thereof in the plane was 10.0%.

### (Comparative Example 1)

Using a disc rotation-type MOCVD apparatus, a 3 µm-thick GaN layer was grown on a circular sapphire (0001) substrate having a diameter of 5.08 cm (2 inches) and a thickness of 430 µm. Furthermore, the GaN film was grown according to the HVPE method by applying a gas at right angle to the substrate surface (the angle of the gas flow was 0° with respect to the normal line of the substrate surface), as a result, cracking or crazing was generated in the grown GaN film. At this time, the film thickness distribution in the wafer plane was 500 µm. Also, a plane other than the (0001) plane grown at the initial state was generated and the wafer showed a rough surface.

The half-width near the center by the X-ray diffraction (0002) was 170 (arcaec), and the variation in the plane was within ±10. The RMS value on the surface was 1 nm in the vicinity of center. Also, the reflectance of light at 365 nm on the wafer surface as measured by using a halogen lamp was 16.5%, and the variation thereof in the plane was 20.8%.

### (Comparative Example 2)

Using a disc rotation-type MOCVD apparatus, a 3 µm-thick GaN layer was grown on a circular sapphire (0001) substrate having a diameter of 5.08 cm (2 inches) and a thickness of 430 µm. The half-width by the X-ray diffraction (0002) of the grown GaN layer crystal was 300 (arcaec). Furthermore, a 25 µm-thick GaN film was grown according to the HVPE method by applying a gas at right angle to the substrate, as a result, the surface of the grown GaN film was partially clouded, and the defect density in the mirror surface portion was as large as 2×10⁸ cm⁻².

### INDUSTRIAL APPLICABILITY

The nitride semiconductor material of the present invention is excellent in the uniformity and stability despite its thickness in a certain level and therefore, very useful, for example, as a substrate for a nitride semiconductor-type device. Also, when the production process of the present invention is used, such a nitride semiconductor material can be mass-produced at a low cost with the use of a conventional growth method or apparatus and a substrate can be provided more inexpensively than a self-supporting substrate, ensuring that the utility value in industry is high. The present invention is suitably applicable, for example, to a light-emitting diode and a semiconductor laser, particularly, a blue or white light-emitting device and a chip or module using the device, and further to a semiconductor device such as electronic device.

## Claims

1. A nitride semiconductor material comprising a semiconductor or dielectric substrate having thereon a first nitride semiconductor layer group, wherein
the surface of said first nitride semiconductor layer group has an RMS of 5 nm or less, a variation of X-ray half-width within ±30%, a light reflectance of the surface of 15% or more, and a variation thereof of ±10% or less, and the thickness of said first nitride semiconductor layer group is 25 µm or more.

2. The nitride semiconductor material as claimed in claim 1, wherein the thickness of said first nitride semiconductor layer group is from 25 µm to 500 µm.

3. The nitride semiconductor material as claimed in claim 1 or 2, which further has a second nitride semiconductor layer group between the semiconductor or dielectric substrate and the first nitride semiconductor layer group.

4. The nitride semiconductor material as claimed in claim 3, wherein the thickness of said second nitride semiconductor layer group is from 1 µm to 50 µm.

5. The nitride semiconductor material as claimed in any one of claims 1 to 4, wherein said substrate has a hexagonal structure or a crystal structure belonging to the hexagonal system.

6. The nitride semiconductor material as claimed in claim 5, wherein said cubic substrate is Si, GaAs, InGaAs, GaP, InP, ZnSe, ZnTe or CdTe.

7. The nitride semiconductor material as claimed in claim 6, wherein said hexagonal substrate is sapphire, SiC, GaN, spinel or ZnO.

8. The nitride semiconductor material as claimed in claim 7, wherein the growth plane of said sapphire substrate is an (ABCD) plane or a plane slightly inclined from the (ABCD) plane wherein A, B, C and D each is a natural number.

9. The nitride semiconductor material as claimed in any one of claims 1 to 8, wherein the thickness of said substrate is from 100 µm to 1 mm.

10. The nitride semiconductor material as claimed in any one of claims 1 to 9, wherein the diameter of said substrate is 2 cm or more.

11. The nitride semiconductor material as claimed in any one of claims 1 to 10, wherein the surface of said first nitride semiconductor layer group is unpolished.

12. The nitride semiconductor material as claimed in any one of claims 1 to 11, wherein the first nitride semiconductor layer group has no spatial periodicity of the defect density with respect to the in-plane direction of said substrate.

13. The nitride semiconductor material as claimed in any one of claims 3 to 12, wherein the second nitride semiconductor layer group exhibits a plurality of different conductivity types.

14. The nitride semiconductor material as claimed in claim 13, wherein said second nitride semiconductor layer group is an n-type semiconductor.

15. The nitride semiconductor material as claimed in claim 14, wherein the n-type GaN contained in said second nitride semiconductor layer group comprises at least one element selected from silicon, oxygen and carbon.

16. The nitride semiconductor material as claimed in claim 13, wherein said second nitride semiconductor layer group is a p-type semiconductor.

17. The nitride semiconductor material as claimed in claim 16, wherein the p-type GaN contained in said second nitride semiconductor layer group comprises at least one element selected from Zn and Mg.

18. The nitride semiconductor material as claimed in any one of claims 3 to 17, wherein the second nitride semiconductor layer group comprises at least any one member of InₓGa₁₋ₓN (0≤x≤1), Al_{y}Ga_{1-y}N (0≤y≤1) and InₓAl_{y}Ga_{z}N (x+y+z=1).

19. The nitride semiconductor material as claimed in any one of claims 3 to 18, wherein the second nitride semiconductor layer group is formed by a metal-organic vapor phase epitaxy method, a pulsed laser deposition method, a pulsed electron deposition method, a hydride vapor phase epitaxy method, a molecular beam epitaxy method, a liquid phase growth method or a mixture thereof.

20. The nitride semiconductor material as claimed in any one of claims 1 to 19, wherein the first nitride semiconductor layer group comprises InₓGa₁₋ₓN (0≤x≤1) or Al_{y}Ga_{1-y}N (0≤y≤1).

21. The nitride semiconductor material as claimed in claim 20, wherein the first nitride semiconductor layer group comprises InₓGa₁₋ₓN (0≤x≤1) or Al_{y}Ga_{1-y}N (0≤y≤1) exhibiting a plurality of different conductivity types.

22. The nitride semiconductor material as claimed in claim 21, wherein said first nitride semiconductor layer group comprises an n-type semiconductor InₓGa₁₋ₓN (0≤x≤1) or Al_{y}Ga_{1-y}N (0≤y≤1).

23. The nitride semiconductor material as claimed in claim 22, wherein the n-type InₓGa₁₋ₓN (0≤x≤1) or Al_{y}Ga_{1-y}N (0≤y≤1) contained in said first nitride semiconductor layer group comprises at least one element selected from silicon, oxygen and carbon.

24. The nitride semiconductor material as claimed in claim 21, wherein said first nitride semiconductor layer group comprises a semi-insulating semiconductor layer.

25. The nitride semiconductor material as claimed in claim 24, wherein said semi-insulating semiconductor layer comprises at least one element selected from Fe, Cr, C and Zn.

26. The nitride semiconductor material as claimed in any one of claims 1 to 25, wherein the first nitride semiconductor layer group has no spatial periodicity of the defect density with respect to the in-plane direction of the first nitride semiconductor layer group.

27. The nitride semiconductor material as claimed in any one of claims 1 to 26, wherein the first nitride semiconductor layer group is formed by a hydride vapor phase epitaxy method or a liquid phase growth method.

28. The nitride semiconductor material as claimed in any one of claims 3 to 27, wherein the first nitride semiconductor layer group and the second nitride semiconductor layer group are continuously formed by the same growth apparatus.

29. A production process of a nitride semiconductor crystal, comprising growing a nitride semiconductor crystal on a substrate by setting the conditions to satisfy at least either one of the following (1) and (2):
(1) the growth rate is set to 30 µm/h or more at the initiation of crystal growth, and
(2) the growth rate is gradually decreased along with the progress of crystal growth.

30. The production process of a nitride semiconductor crystal as claimed in claim 29, wherein a nitride semiconductor crystal is grown on said substrate by flowing a gas from an angle of 45° to 90° with respect to the normal line of the substrate surface.

31. The production process of a nitride semiconductor crystal as claimed in claim 30, wherein the temperature at the substrate end part on the upstream side with respect to the flow of said gas is set higher than the temperature at the substrate end part on the downstream side.

32. The production process of a nitride semiconductor crystal as claimed in claim 31, wherein a value obtained by dividing the difference of temperature between the substrate end part on the upstream side and the substrate end part on the downstream side by the distance between the upstream end part and the downstream end part is from 0.5°C/cm to 10.0°C/cm.

33. The production process of a nitride semiconductor crystal as claimed in any one of claims 29 to 32, wherein a hydrogen chloride gas is contained in the gas supplied.

34. The production process of a nitride semiconductor crystal as claimed in claim 33, wherein the hydrogen chloride gas concentration in the gas supplied is decreased along with the progress of crystal growth.
